# EUROPEAN PATENT SPECIFICATION

(11) **EP 4 167 696 B1**
(45) Date of publication and mention of the grant of the patent: **04.06.2025**
(21) Application number: 21202418.6
(22) Date of filing: 13.10.2021
(51) Int. Cl.: H05K 7/14, H05K 5/00

(54) **ELECTRICAL ELEMENT WITH CLEARANCE-FREE FIXATION OF A PLATE MEMBER**
ELEKTRISCHES ELEMENT MIT SPIELFREIER FIXIERUNG EINES PLATTENELEMENTES
ÉLÉMENT ÉLECTRIQUE AVEC FIXATION SANS JEU D'ÉLÉMENT DE PLAQUE

(43) Date of publication of application: 19.04.2023
(73) Proprietor: TE Connectivity India Pvt Ltd, Bangalore 560 066 (IN); TE Connectivity Germany GmbH, 64625 Bensheim (DE)
(72) Inventor: Kraemer, Christoph, 67346 Speyer (DE); Manivasakan, Ravinthiran, 560 066 Bangalore (IN); Pooventhan, A, 560 066 Bangalore (IN)
(74) Representative: Grünecker Patent- und Rechtsanwälte PartG mbB

(56) References cited:
- US-A1- 2016 143 158

## Description

The invention relates to an electrical element with a clearance-free fixation of a plate member.

Electrical elements, e.g. elements comprising or carrying at least one electrical component, are applied in various environments and may comprise a plate member supporting the electrical component. Various means for fixing said plate member in the electric component are known. Known fixation approaches, however, are cumbersome, require several process steps and are prone to assembly errors. US 2016/1431258 A1 describes an electronic control device that houses a circuit board by sliding it along a pair of guide grooves.

One aspect of the present invention is therefore to render the assembly of electrical elements easier and less error-prone. The invention is as defined by claim 1.

The present invention improves prior art electrical elements by comprising a first housing part, a plate member, and a second housing part, wherein the first housing part comprises a plate insertion section, the plate insertion section being adapted to guide an insertion of the plate member along an insertion direction into a mounting position of the plate member at the first housing part, wherein the second housing part comprises at least one locking element that forms a locking with a corresponding counter locking element of the first housing part, and wherein the second housing part further comprises at least one latching element adapted to engage a corresponding counter latching element of the plate member, the at least one latching element and the corresponding counter latching element, in an engaged state, form a latching.

The inventive electrical element thus has the advantage over prior art solutions that no cumbersome, difficult and time-consuming fixation is necessary. The inventive electrical element is thus easier assembled and prevents assembly errors.

The inventive electrical element may be improved by specific embodiments, which will be described in the following.

The plate member may be an electric plate member, i.e. a plate that provides an electric device or part, such as, and not limiting, a connector interface and/or any kind of sensor such as an optical sensor, temperature sensor, humidity sensor, magnetic sensor, eddy current sensor, current sensor or the like.

The plate member may be a printed circuit board or a printed circuit board assembly.

The inventive electrical element is clearance free, i.e. the first housing part receiving the plate member may be attached to the second housing part without the need of gluing, screwing, hot stamping, riveting or the like, the electrical element further being resistant against vibrations.

The first and the second housing part may be provided as separate pieces or may be connected to each other by a hinge, e.g. a film hinge.

The insertion direction may correspond to a direction of a linear movement of the second housing part towards the first housing part. If a hinge is provided between the first and the second housing part, an assembly direction may be described by a sector of a circle, indicating a tilting movement of the second housing part with respect to the first housing part.

The assembly direction along which the second housing part is moved towards the first housing part may correspond to the insertion direction of the plate member. The assembly direction may be oriented perpendicular to the insertion direction in a different embodiment of the electrical element. The assembly direction may be oriented perpendicular to the inserted plate member, such that the second housing part may be attached to the first housing part along a second possible assembly direction (for instance a downward direction) or along a third possible assembly direction (for instance an upward direction). If the first and second housing part are attached to each other along the second or third assembly direction, the latching element and the counter latching element may be brought into engagement with each other in a sliding movement. Positioning of the latching element and the counter latching element may be provided by chamfers of the corresponding elements. In case a hinge connects the first and the second housing part, a direction of the tilting movement of the second housing part with respect to the first housing part may approach the insertion direction prior to the engagement of the latching.

The locking and the latching both describe fixation principles, wherein a locking (German: Gesperre), once engaged, may not be released by a force (without destruction of the elements forming the locking), whereas a latching (German: Gehemme), once engaged may be released by a force that overcomes a latching force, a latching friction or the like. Both, locking and latching, may be based on a positive fit between at least two elements

The latching may require a tool to be released. The locking may, however, also be released if locking elements are dislocated from the counter locking elements. This dislocating movement may require a tool as well.

The electrical element may thus be in an unassembled state, in which the plate member is not yet received within the plate insertion section, and neither the locking nor the latching are engaged. The electrical element may be in a pre-assembly state if the plate member is received in the plate insertion section and the locking is engaged. Finally, if the plate member is received in the plate insertion section and the locking and latching are engaged, the electrical element may be in an assembled state.

The locking element, the counter locking element, the latching element and the counter latching element may be provided twice, thrice or more than three times, wherein preferably each of the locking elements has a corresponding counter locking element and, accordingly, each latching element has a counter latching element. Within this disclosure, mentioning features or functions of only one of the above elements does not exclude the presence of one or more elements having the same features or functions. Similarly, if the plural form of elements is applied, the features and/or functions described within the context of an embodiment of the electrical element comprising two locking or latching elements does not exclude another embodiment of the inventive electrical element comprising one single locking or latching element, one single counter locking or counter latching element having the same features and/or functions.

The electrical element may have a cuboid shape, wherein the plate insertion section may be provided close to a first surface of the cuboid. In the pre-assembly state and the assembled state, arms of the second housing part may at least partially surround the first housing part. The arms of the second housing part may be provided at or close to a respective further surface of the cuboid, the first surface may be oriented perpendicular to the further surface. The locking elements and/or the counter locking elements and/or the latching elements and/or the counter latching element may be provided pairwise at opposing sides of the first or second housing part.

The electrical element may be improved in that the plate insertion section comprises at least one slot for guiding the plate member. A slot has the advantage of easily guiding a plate member.

The slot may be formed or defined by guiding recesses or guiding protrusions that extend along the insertion direction, e.g. a slotted hole or a guidance formed by an elongated extended structure. The slot and side edges of the plate member may engage in a form fit that may prevent a movement of the plate member relative to the slot in any direction perpendicular to the insertion direction, wherein a residual degree of freedom of moving the plate member in or against the insertion direction into or out of the slot may remain.

Also, the plate member may comprise a slot, such that a guidance similar to a dovetail guidance is formed.

The at least one slot may comprise guiding members that are arranged sectionwise that are spaced apart from each other along the insertion direction. The guiding members may extend or may be formed by one side surface of the first housing part along a direction perpendicular to the insertion direction and may be bent towards an opposite surface, such that a projection overhang may limit the slot. Along the insertion direction, the guiding members may be provided only on one side or preferably pairwise on opposing sides of the first housing part. Along the insertion direction, at least two guiding members may be provided per side.

A further embodiment of the inventive electrical element may be improved in that the plate insertion section comprises a stop limiting the insertion of the plate member along the insertion direction and defining the mounting position. The mounting position is thus easily arrived at when the plate member is received in the insertion section. The stop may comprise a pocket into which the plate member is at least partially inserted in the mounting position. Such a pocket may have two functions, namely to stop further insertion of the plate member into the plate insertion section and to prevent the plate member from being removed from the plate receiving section in a direction perpendicular to the inserting direction, and thus further securing the positioning of the plate member within the plate insertion section.

The plate member being in the mounting position may thus have an outer surface accessible from outside the electrical element and an inner surface facing away from the outside and not accessible therefrom. In addition or alternatively to the pocket, the electrical element may comprise an internal spring pressing against the inner surface of the plate member, which in turn presses against guiding members of the slot. Such an internal spring may further increase the stability and vibration resistance of the plate member received and fixed in between the first and second housing part.

In a further advantageous embodiment of the inventive electrical element, the latching element comprises a spring member. The spring member may be deflectable along a direction perpendicular to the insertion direction. The spring member may comprise a rest state, also referred to as stable state, and a latched state, also referred to as metastable state. The rest state represents the initial state of the spring member without interaction with further elements or parts of the plate member or to first housing part. The latched state may only be maintained upon interaction with a further element of the plate member or the first housing part. In another embodiment, the spring member may be a bistable spring member.

The spring member may be in the rest state in the unassembled state of the electrical element and in the pre-assembly state of the electrical element. In the assembled state of the electrical element, the spring member may be in a latched state.

That is, the spring member is in a latched state if the plate member is in the mounting position and the latching is engaged. The latched state of the spring member may be reached in particular only if the plate member is in the mounting position.

In this latched state, the spring member may be deflected with respect to a rest state of the spring member. Changing the state of the spring member is thus performed by a deflection, in particular by a tilting movement of arms of the second housing part that comprise the spring member. The spring member may thus be formed by a surface of the second housing part that may connect the latching elements to a body of the second housing part.

In a further embodiment of the inventive electrical element, the counter latching element may be formed by a counter latching surface, wherein, when the latching is engaged, the at least one latching element of the second housing part presses against the counter latching surface, thereby pressing the plate member in the mounting position. Thereby, fixing the plate member in the mounting position is assured.

The counter latching surface of the plate member may be a shoulder being oriented essentially perpendicular to the insertion direction. The counter latching surface may further comprise a slope or inclination in the insertion direction, i.e. that at least sectionwise, portions of the counter latching surface may be located closer to a center of the plate member, said portions also being located further in the insertion direction.

The electrical element may be further improved by the counter latching surface comprising a curvature in or opposite to the insertion direction. The curvature of the counter latching surface may be convex and a curvature of the latching member of the second housing part may be concave. In another embodiment of the electrical element, those curvatures may be inverse. Further, the shape of the surface may correspond to a 'V', a 'U', or may simply comprise a slope having a shape similar to a saw tooth. It is also conceivable that the counter latching surface has the shape of a 'U' or 'V' and the latching elements of the second housing part having a convex curvature.

The latching member and the counter latching member may provide an acoustical and/or haptic feedback when the latching is engaged. Engaging the latching may generate an acoustic feedback in the form of a clack sound similar to the one produced by a crack-frog. The engagement may further generate a shockwave that may be sensed as haptic feedback of the engagement of the latching.

In a further advantageous embodiment of the inventive electrical element, the latching elements are resiliently connected to a body of the second housing member by a push force member adapted to hold the latching elements resiliently along the insertion direction. In order to engage the latching, it may be necessary that an initial barrier provided by the counter latching surface is overcome. The initial barrier may result in an initial deflection force necessary to deflect the latching elements in a direction opposite the insertion direction by compressing the push force member in the same direction. The deflection of the latching member of the second housing part allows moving the latching member past an edge of the counter latching surface, wherein the push force member is at least partially released after passing said edge.

The push force member may be provided by an elastic portion of a sidewall of the second housing part, said elastic portion connecting the body of the second housing part with the latching elements. The push force member may have a ring-shaped or S-shaped structure or web.

Further different shapes of the push force member are conceivable, for instance and not limiting an anti-S-form, a V-shape, a z-shape, an L-shape or simply a bending bar. The push force member may be a flexible or elastic element with a structure similar to a meander structure.

The spring member may comprise an intermediate state between the rest state and the latched state, in which the push force member exerts an intermediate push force onto the plate member in the insertion direction. During switching from the rest state to the latched state of the spring member, an initial force has to be overcome to engage the latching. Prior to reaching the latched state, when the latching is engaged, the spring member is in the intermediate state. The intermediate state being non-stable, i.e. the latching elements automatically move further towards the latched state.

It is particularly advantageous for an embodiment of the electrical element if the push force member exerts a permanent push force onto the plate member in the insertion direction in the latched state of the spring member. The permanent push force is preferably smaller than the intermediate push force. This permanent push force may guarantee a clearance-free lifetime fixation without the need for other fixation methods, such as e.g. gluing.

In the electrical element, if the at least one latching element is engaged with the corresponding counter latching element, the at least one locking element is pressed against the corresponding counter locking element. Accordingly, two (three, four, N) locking elements may engage with two (three, four, N) corresponding counter locking elements. Additionally, any number of latching elements and the corresponding number of counter latching elements may be provided, which may be pressed against each other with the latching engage. The at least one latching element engaging the corresponding counter latching element may engage in a press-fit.

In another advantageous embodiment of the inventive electrical element, the first housing part comprises two plate insertion sections. Additionally or alternatively, at least one or both plate insertion sections may comprise a slot each. Each slot may be provided on opposing sides of the first housing part. Accordingly, two individual plate members may be received, one plate member in each of the plate insertion sections. Additionally or alternatively, the plate member may be a bent plate member. Such a bent plate member may have two ends. At least one plate member, or two plate members or the two ends of the bent plate member may be embodied as an elongated printed circuit board, briefly: PCB, or as a printed circuit board assembly, briefly: PCBA. The PCB or PCBA may comprise two ends or end sections. Advantageously, each of the plate insertion sections may be adapted to guide an insertion of one individual plate member or one end of the bent plate member into the first housing part, and wherein each individual plate member or each end of the bent plate member may comprise at least one counter latching element adapted to engage a corresponding latching element of the second housing part.

The two ends may be connected by an intermediate section. The two ends may also be electrically connected to each other. The intermediate section may comprise curved sections with a lower thickness than the ends. These curved sections may provide a flexibility and a spring-like behavior. If the electrical element is assembled, the ends of the PCB may be fixed and the intermediate section may be pressed in an assembly direction, thereby exerting a force onto the curved sections, that act as pre-tensioned springs, thereby holding the PCB in place in the electrical element. The electrical element may be applied as an eBrake sensor providing detection means. Some embodiments of this electrical element may comprise at least one Hall sensor, preferably provided on one end of the PCB, and may further additionally or alternatively comprise contact pads for contacting the sensor on the opposite end of the PCB. The above features may be individually provided with any previously described embodiment of the inventive electric connector.

In a further advantageous embodiment of the inventive electrical element, the second housing part may comprise at least one pair, preferably at least two pairs of opposing latching elements. In another embodiment, at least two latching elements may be provided on one side of the second housing part being connected to each other by a synchronization member that is adapted to be deflected in a direction perpendicular to the insertion direction, thereby moving the latching elements provided on one side of the second housing part from the stable position to the second position.

The electrical element may comprise an S-shaped push force member. Said member may generate the permanent push force. In particular, the first housing part may have four locking members. Accordingly, the second housing part may have four counter locking elements.

In one embodiment, each end of the PCB may have two counter latching elements. Thus, four of such sections/members may be provided. Accordingly, the second housing part may have four latching members that may be connected by a bar.

In particular, locking elements and latching elements may be provided on opposite sides of the first and/or second housing part.

The first housing part and the second housing part may be connected to each other by approaching both housing parts towards each other along the insertion direction.

Alternatively, if a hinge is present, engagement of the first and second housing part may occur in a tilting movement.

In one alternative embodiment, the second housing part may be engaged with the first housing part from top to bottom. Here, alternative latching elements have to be provided, respectively the previously described latching elements (e.g. locking beaks) have to be reconfigured. The latching elements provided at the second housing part need to be adapted to this alternative movement, e.g. by a chamfer. This embodiment does not give an acoustic or haptic feedback as the curved bar is directly slided along the curved section of the plate member.

As outlined above, the electrical element may comprise one or more plate insertion sections, one or more locking elements, counter locking elements, latching elements or counter latching elements as well as one or more plate members.

In the following, the invention will be described using exemplary embodiments, which are shown in the accompanying figures.

The embodiments that will be shown merely represent exemplary embodiments of the present invention.

All technical features having the same technical effect will be denoted with the same reference numeral. A repetitive description of already described technical features will be omitted. The described embodiments are to be understood as not limiting the scope of protection, which is defined by the claims.

In the figures:
- Fig. 1: illustrates a first embodiment of the inventive electrical element in an exploded view;
- Fig. 2: illustrates the embodiment of Fig. 1 in a pre-assembled state;
- Fig. 3: illustrates the embodiment of Fig. 1 in an assembled state;
- Fig. 4: illustrates another embodiment of the inventive electrical element without second housing part;
- Fig. 5: illustrates the embodiment of the inventive electrical element of Fig. 4 in the pre-assembled state;
- Fig. 6: illustrates the embodiment of Fig. 4 in the assembled state;
- Fig. 7: illustrates the working principle of the latching;
- Fig. 8: shows another embodiment of the inventive electrical element in an exploded view;
- Fig. 9: illustrates the electrical element of Fig. 8 with the plate member being received;
- Fig. 10: shows the electrical element of Fig. 8 and Fig. 9 in the assembled state; and
- Fig. 11: illustrates yet another embodiment of the inventive electrical element.

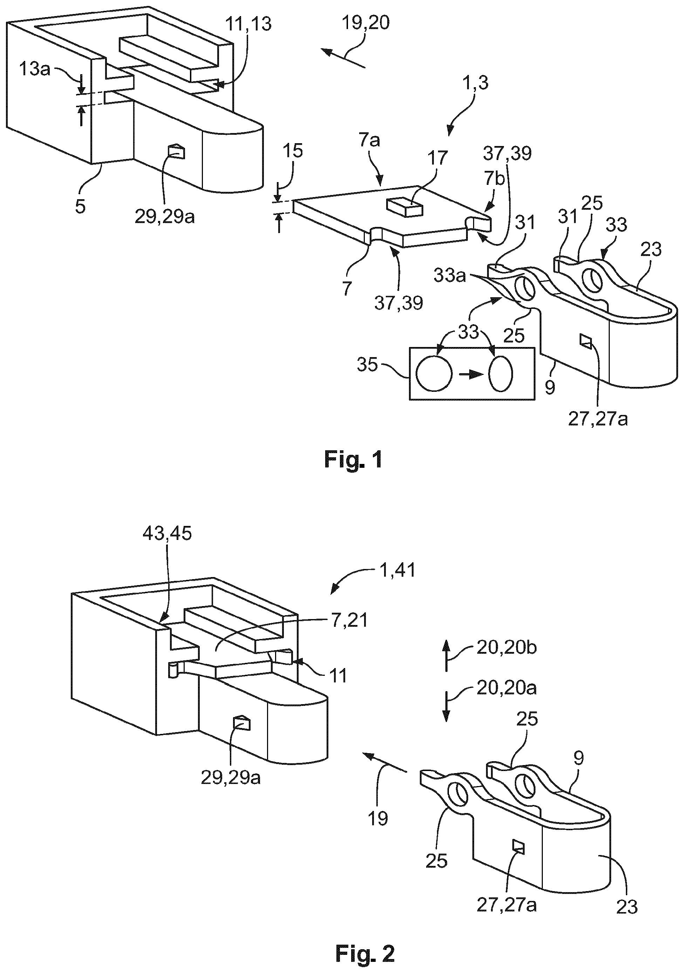

In Figs. 1 to 3 an electrical element 1 is shown in an exploded view 3. The electrical element 1 comprises a first housing part 5, a plate member 7 and a second housing part 9.

The first housing part 5 may have a cuboid or cubic shape but is not limited to those shapes and may comprise a rounded or curved outside shape.

The first housing part 5 comprises a plate insertion section 11, which comprises, respectively is formed by a slot 13 in the embodiment shown in the figures. The slot 13 having a slot width 13a corresponding or being at maximum 10% larger than a thickness 15 of the plate member 7. The plate member 7 is adapted to provide electrical components as for instance a printed circuit, a printed circuit assembly, connector elements, sensors or the like. In Fig. 1 an electrical component 17 is schematically shown and is to be understood as being representative for possible further connector elements not limited by the list given above.

The plate insertion section 11 is adapted to guide an insertion of the plate member 7 along an insertion direction 19 into a mounting position 21 that is shown in Fig. 2.

The plate member 7 has a longitudinal shape with a front side 7a and a rear side 7b, wherein the plate member 7 is inserted into the plate insertion section with the front side 7a. In different embodiments of the inventive electrical element 1, a Poka-yoke feature (inadvertent error prevention feature, not shown in the figures) may be provided, e.g. in the form of a cross-section of the slot 13 not showing rotational symmetry.

The second housing part 9 comprises a body 23 and two arms 25 extending from the body 23. In the body 23, two locking elements 27 are provided. In different embodiments of the inventive electrical element 1, only one locking element 27 may be provided. The two locking elements 27 are embodied as locking recesses 27a and one of them is hidden by the body 23.

The second housing part 9 has a U-shape, the basis of the U being formed by the body 23.

The locking elements 27 of the second housing part 9 form a locking (see Fig. 2) with a corresponding counter locking element 29 of the first housing part. In the embodiment shown, the counter locking element 29 is embodied as a locking beak 29a.

The second housing part 9 further comprises two latching elements 31 that are provided at the arms 25. In different embodiments of the electrical element 1, the latching elements 31 may be provided at different positions and connected to the body 23 via different members. In another embodiment, only one latching element 31 may be provided. The latching elements 31 of the embodiment shown are connected and/or held to/at the body 23 by a push force member 33. The push force member 33 is compressible by deforming to ring sections 33a of the push force member 33, as shown in the sketch 35 below the second housing part 9.

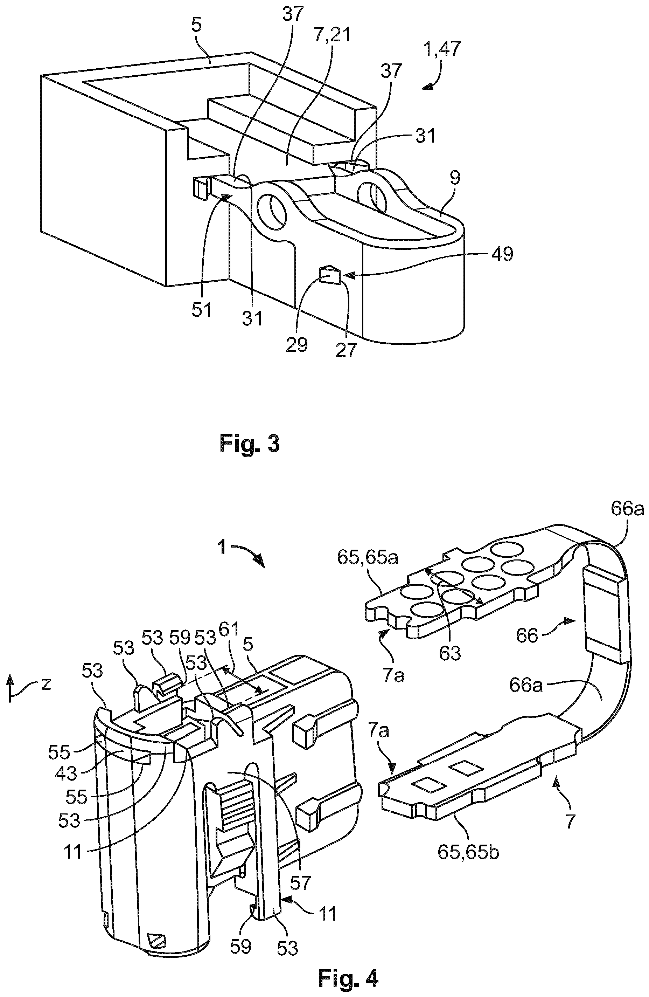

The latching elements 31 of the second housing part 9 are adapted to engage corresponding counter latching elements 37 of the plate member 7 to engage a latching (not shown, see Fig. 3). In the embodiment shown, the counter latching elements 37 of the plate member 7 are embodied as counter latching surfaces 39.

In Fig. 2, the electrical element 1 is shown in a pre-assembled state 41, in which the plate member 7 is inserted into the plate insertion section 11 along the insertion direction 19 until the mounting position 21 is reached. The mounting position 21 is defined by a stop 43 that limits the insertion of the plate member 7 along the insertion direction 19. In the embodiment shown, the stop 43 is provided by a front wall 45 of the first housing part 3.

In a next step during the assembly of the inventive electrical element 1, the second housing part 9 is moved along the insertion direction 19, such that the locking elements 27 of the second housing part 9 engage the counter locking elements 29 of the first housing part 5. This locking is performed such that the body 23, in particular the arms 25 of the second housing part 9 abut the locking beak 29a and are deflected outwards, such that an inner surface of the body 23 slides along the locking beak 29a, until the locking beak 29a reaches the locking recess 27a. Here, the deflected arms 25 return to their initial position shown in Fig. 1.

The insertion direction 19 may correspond to an assembly direction 20, along which the second housing part 9 is assembled to the first housing part 5.

In different embodiments of the inventive electrical element 1, the assembly direction 20 may be oriented perpendicular to the insertion direction 19. Possible further assembly directions 20 are a second possible assembly direction 20a and a third possible assembly direction 20b. Further assembly directions 20 are not excluded.

In case the second housing part 9 is latched to the first housing part 5 along the second 20a or third possible assembly direction 20b, the locking beaks 29a shown in Fig. 1 and Fig. 2 may comprise a modified slope or chamfer that may at least partially face against the chosen further assembly direction 20a or 20b. Those modified locking beaks 29a are not shown in the figures.

In Fig. 3 the electrical element 1 is shown in an assembled state 47, in which the locking elements 27 form a locking 49 with the corresponding counter locking elements 29 of the first housing part 5 and, additionally, the latching elements 31 of the second housing part 9 engage a latching 51 with the counter latching elements 37 of the plate member 7. Is to be noted that the latching 51 is only possible if the plate member 7 is in the mounting position 21.

In the following Figs. 4 to 7 another embodiment of the inventive electrical element 1 is described.

Fig. 4 shows the electrical element 1 without the second housing part 9.

In this embodiment, the plate insertion section 11 is formed by sectionwise arranged guiding members 53, which are spaced apart from each other along the insertion direction 19.

Further, the stop 43 additionally comprises two pockets 55 (in other embodiments, only one pocket 55 may be provided), in which a front side 7a of the plate member may be at least partially received.

The guiding members 53 extend from a side wall 57 of the first housing part 5 and form an overhang structure 59, a free space 61 between opposing overhang structures 59 is smaller than a plate width 63. The overhangs structures 59 will hold the plate member 7 in the plate insertion section 11 and prevent it from being moved out of the plate insertion section 11 in a z-direction.

Further, in the embodiment shown, a second plate insertion section 11 is provided in a lower part of the first housing part 5. This second plate insertion section 11 is formed similarly as the upper plate insertion section 11, i.e. also with guiding members 53. The two plate insertion sections 11 may be embodied identical or different, i.e. for instance also being formed by a slot 13 as shown in Fig. 1 to Fig. 3 of the first embodiment of the inventive electrical element 1.

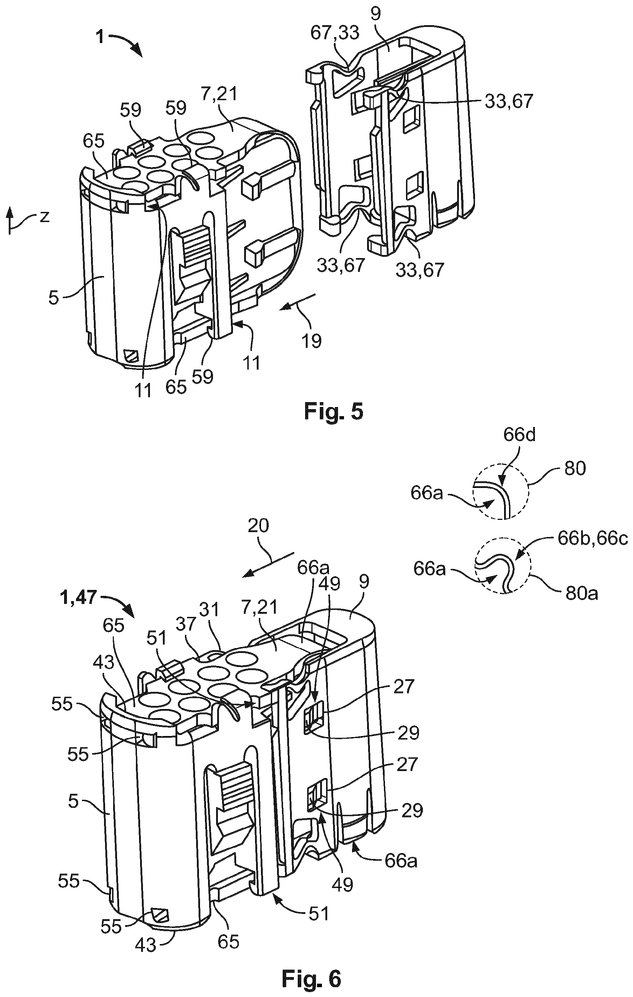

The plate member 7 shown in this embodiment has a U-shape and comprises two ends 65, a first end 65a and a second end 65b, which distinguish from each other by their front side 7a that is different to prevent incorrect mounting of the plate member 7 into the first housing part 5. Both ends 65a and 65b are connected to each other by an intermediate section 66 that may connect both ends 65 mechanically and/or electrically with each other. The plate member 7 shown may be pre-bent. The intermediate section 66 comprises two curved sections 66a in the embodiment shown. These curved sections 66a have a low relaxation and due to a thickness (not shown) smaller than the thickness of the ends 65a and 65b, provide a spring behavior that will be described with reference to Fig. 6

In Fig. 5, the plate member 7, more precisely the two ends 65 of the plate member 7, are each received within the corresponding plate insertion section of the first housing part 5. As can be seen, the overhangs structures 59 prevent the ends 56 from being moved out of the corresponding plate insertion sections 11 along, respectively opposite to the z-direction.

The only remaining degree of freedom for moving the plate member 7 is opposite to the insertion direction 19.

Finally, Fig. 6 shows the inventive electrical element 1 in the assembled state 47. In the assembled state 47, the plate member 7 is in the mounting position 21 and partially received in pockets 55 of the stops 43. The locking 49 between locking elements 27 of the second housing part 9 and counter locking elements 29 of the first housing part 5 is engaged, in the embodiment shown, each side provides two engaged locking 49. Further, also the latching 51 is engaged between latching elements 31 of the second housing part 9 and counter latching elements 37 of the plate member 7. For each end 65 of the plate member 7 latching 51 is engaged between two latching elements 31 and two counter latching elements 37. Latching 51 will be described in more detail in the next figure.

In the assembled state 47, the ends 65 of the plate member 7 are fixed and the intermediate section 66 (not visible) is pressed in the assembly direction 20 by means of the second housing part 9. The curved sections 66a (see Fig. 4) act as a compressed spring 66b because of a deformation 66c thereof. The deformation 66c is schematically shown in a second circle 80a in comparison with an undeformed state 66d of the curved section 66a shown in a first circle 80. because of the curved sections 66a acting as compressed spring 66b, the plate member 7 is additionally fixed between the first housing part 5 and the second housing part 9.

With reference to Fig. 5 and Fig. 6 it is noted that the push force member 33 of the second embodiment of the inventive electrical element 1 is formed by an S-shaped spring member 67. In the embodiment shown, four push force members 33 are provided, wherein in other embodiments a different number of push force members 33 is conceivable, e.g. one, two, three, five or more. It is preferable that push force members 33 are provided pairwise for achieving symmetric latching.

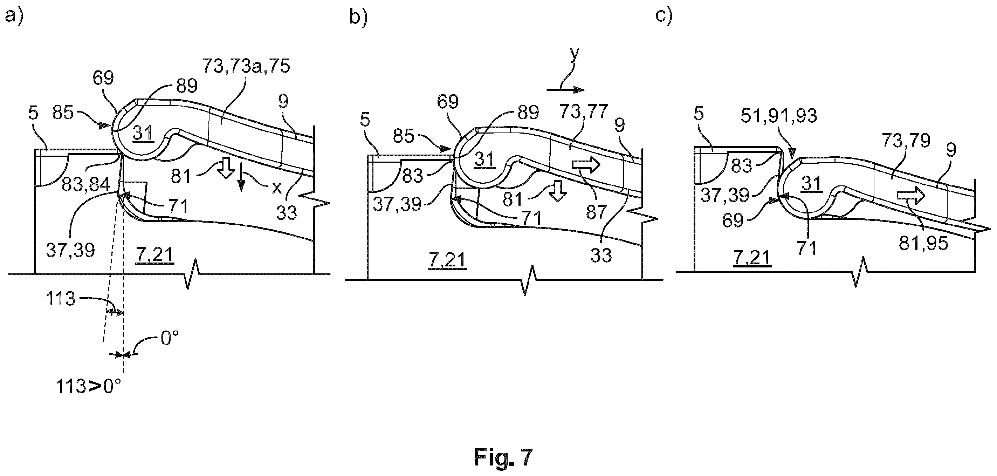

Fig. 7 illustrates a working principle of the latching 51 and shows the latching element 31 of the second housing part 9 and the counter latching element 37 of the plate member 7 in more detail. Fig. 7 shows said details in top view.

As can be seen, the latching element 31 has a convex surface 69 and the counter latching element 37, being a counter latching surface 39, has a concave surface 71.

The second housing part 9 comprises a spring member 73 that connects the latching element 51 with the body 23 (not shown here) of the second housing part 9. In the left panel a), the spring member 73 is in a rest state 75 and the plate member 7 is in the mounting position 21.

The spring member 73 may be a bistable spring member 73a.

The latching 51 may be engaged by exerting a latch force 81 in an x-direction. It is noted that the latch force 81 for engaging the latching 51 of the opposing latching element 31 with the opposing counter latching element 37 is directed opposite the x-direction shown here. Because of the latch force 81, the convex surface 69 of the latching element 31 abuts a comer 83 of the counter latching element 37, which, due to a curvature 85, exerts a compression force 87 in a y-direction onto the spring member 73. This compression force 87 deforms the push force member 33 as shown in sketch 35 in Fig. 1.

The corner 83 may be a touch point of looking 84. From this touch point of looking 84 the concave surface 71 spans and angle 113 larger or equal 0°.

The compression force 87 is the largest when an apex 89 of the convex surface 69 surpasses the corner 83. Upon further moving, e.g. deflecting the spring member 73 in x-direction, the necessary latch force 87 as well as the generated compression force 87 decrease.

Finally, as shown in panel c), the convex surface 69 of the latching element 31 and the concave surface 71 of the counter latching element 37 engage latching 51, which may in particular be based on positive locking 91 and more particular represent a press-fit 93.

In panel b), the spring member 73 is in an intermediate state 77 and in panel c), the spring member 73 is in a latched state 79.

If latching 51 is engaged, i.e. the spring member 73 is moved from the intermediate state 77 of panel b) to the latched state 79 of panel c), an acoustic and/or haptic feedback is generated that indicates correct latching 51.

By a remaining latch force 81, the spring member 73 holds the plate member 7 in the mounting position 21, the plate members at the stop 43 against the first housing part, wherein the residual latch force 81 is also, at least partially, exerted from the locking element 27 of the second housing part onto the counter locking element 29 of the first housing part. Thus, locking 49 as well as a latching 51 is secured by a permanent push force 95 being equal to the latch force 81 of panel c).

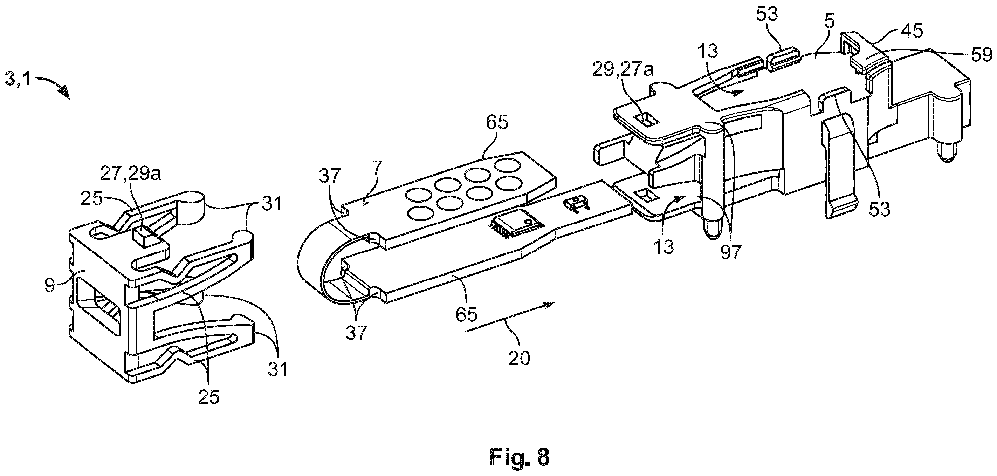

In Fig. 8 to Fig. 10, another embodiment of the inventive electrical element 1 is shown. This embodiment differs from the previously shown embodiments in the shape of the first housing part 5, the plate member 7 and the second housing part 9. The plate member 7 does for instance provide ends 65 of different lengths. The other features like the arms 25 and their behavior with respect to deflection, flexibility and the like are similar to a corresponding features of the previous embodiments.

Also in this embodiment, guiding members 53 are provided that at least partially form the slots 13. in this embodiment, also the front wall 45 of the first housing part 5 comprises an overhang structure 59. Each slot 13 comprises, in addition to the guiding members 53, a roof member 97 that forms or limits the slot 13. In the embodiment shown in Fig. 8 to Fig. 10, the locking element 27 of the second housing part 9 is formed as a locking beak 29a and the counter locking element 29 of the first housing part 5 is formed as a locking recess 27a, wherein locking and counter locking elements 27, 29 are arranged in a plane (not shown) perpendicular to the arrangement of the latching element and the counter latching element 31 and 37.

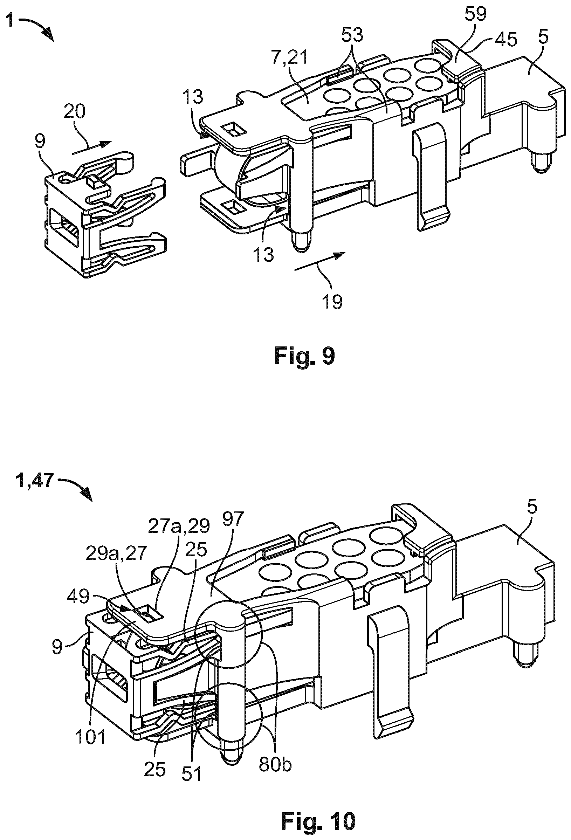

Because of the roof members 97 and two connecting features 99 that connect the roof members 97, the arms 25 of the second housing part and 9 may not deflect the way from the plate member 7 any longer if the second housing part is moved in the assembly direction 20 so far that the latching elements past the connecting features 99. The latching 51 thus is guided and no bistable locking movement of the arms 25 is necessary in this embodiment. Latching 51 and the block a movement of the arms 25 is shown in two third circles 80b in Fig. 10.

The roof members 97 therefore have two functions, namely to provide a guiding for the latching elements 31 and to provide the counter locking elements 29.

In Fig. 9, the plate member 7 is in the mounting position 21, i.e. received within the slots 13 of the first housing part 5. The plate member 7 is secured by the roof member 97, the guiding members 53 and the overhang feature 59 of the front wall 45. The only remaining degree of freedom along which the plate member 7 may be moved is in or opposite to the insertion direction 19.

The second housing part 9 will subsequently be assembled to the first housing part 5 along the assembly direction 20 that corresponds to the insertion direction 19. It is noted that this embodiment does not allow assembly along the second 20a or the third possible assembly direction 20b indicated in Fig. 2.

In Fig. 10, the electrical element 1 this in the assembled state 47. The locking 49 between the locking elements 27 of the second housing part 9 and the counter locking elements 29 of the first housing part 5 is engaged. Similarly, the latching 51 is engaged as well. The latching elements 31 and the counter latching elements 37 are not visible in Fig. 10.

In order to engage the locking 49, the roof members 97 may be resiliently deflectable away from the second housing part 9 upon approaching of a bar section 101 of the roof member 97 towards the locking beaks 29a.

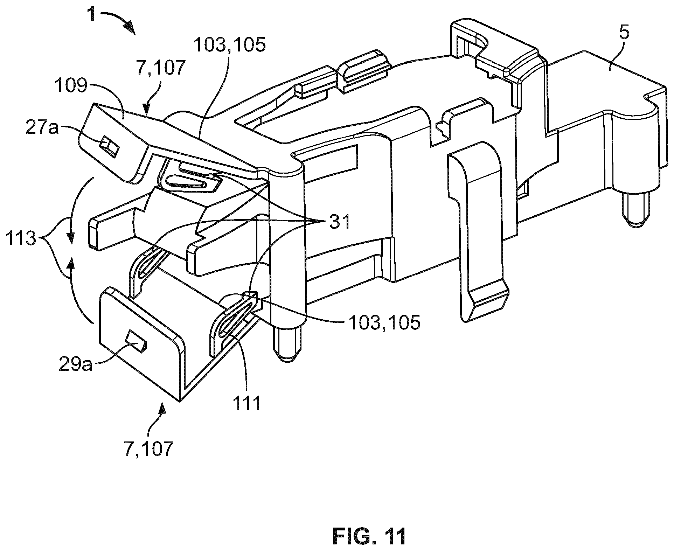

Fig. 11 shows yet another embodiment of the inventive electrical element 1, wherein the first housing part 5 is monolithically connected to the second housing part 9 by means of a hinge 103, in particular a film hinge 105. The second housing part 9 is thus may be understood as a functional element 107 of the first housing part 5. The functional element 107 is composed of a first functional portion 109 and a second functional portion 111, wherein the first functional portion 109 comprises a locking recess 27a and the second functional portion 111 comprises a locking beak 29a.

In the embodiment shown, each of the functional elements 107 comprise two latching elements 31. Further, Fig. 11 does not show a plate member 7 for the sake of visibility. The embodiment of the inventive electrical element 1 of Fig. 11 may receive a plate member as shown in Fig. 8. During assembly of the electrical element 1 the functional portions 109, 111 are moved towards each other along a tilting direction 113. The tilting direction 113 is different for the two functional portions 109, 111. The process of receiving a plate member 7 (not shown) into the first housing part 5 of the embodiment shown in Fig. 11 is similar to the process of receiving the plate member 7 as illustrated in Fig. 9.

If the first functional portion 109 and the second functional portion 111 are closed along the tilting direction 113, the resilient latching elements 31 engage their convex surface 69 with the concave surface 71 of the counter latching element 37 of the plate member (see Fig. 7, panel c)). A push force exerted by the latching elements 31 onto the counter latching elements 37 (not shown) thus may help positioning the plate member 7 in the mounting position 21 (see Fig. 9). The permanent push force 95 will be exerted onto the plate member 7 over the lifetime of the electrical element 1, as in the previously described embodiments.

### REFERENCE NUMERALS

- 1: electrical element
- 3: exploded view
- 5: first housing part
- 7: plate member
- 7a: front side
- 7b: rear side
- 9: second housing part
- 11: insertion section
- 13: slot
- 13a: slot width
- 15: thickness
- 17: electrical component
- 19: insertion direction
- 20: assembly direction
- 20a: second possible assembly direction
- 20b: third possible assembly direction
- 21: mounting position
- 23: body
- 25: arm
- 27: locking element
- 27a: locking recess
- 29: counter locking element
- 29a: locking beak
- 31: latching element
- 33: push force member
- 33a: ring sections
- 35: sketch
- 37: counter latching element
- 39: counter latching surface
- 41: pre-assembled state
- 43: stop
- 45: front wall
- 47: assembled state
- 49: locking
- 51: latching
- 53: guiding members
- 55: pocket
- 57: side wall
- 59: overhang structure
- 61: free space
- 63: plate width
- 65: end
- 66: intermediate section
- 66a: curved section
- 66b: compressed spring
- 66c: deformation
- 66d: undeformed state
- 65a: first end
- 65b: second end
- 67: S-shaped spring member
- 69: convex surface
- 71: concave surface
- 73: spring member
- 73a: bistable spring member
- 75: rest state
- 77: intermediate state
- 79: latched state
- 80: first circle
- 80a: second circle
- 80b: third circle
- 81: latch force
- 83: corner
- 84: touch point of locking
- 85: curvature
- 87: compression force
- 89: apex
- 91: positive locking
- 93: press fit
- 95: permanent push force
- 97: roof member
- 99: connecting feature
- 101: bar section
- 103: hinge
- 105: film hinge
- 107: functional element
- 109: first functional portion
- 111: second functional portion
- 113: angle

## Claims

1. Electrical element (1), comprising
- a first housing part (5);
- a plate member (7); and
- a second housing part (9),
wherein the first housing part (5) comprises a plate insertion section (11), the plate insertion section (11) being adapted to guide an insertion of the plate member (7) along an insertion direction (19) into a mounting position (21) of the plate member (7) at the first housing part (5),
wherein the second housing part (9) comprises at least one locking element (27) that forms a locking (49) with a corresponding counter locking element (29) of the first housing part (5), and
**characterised by**
the second housing part (9) further comprises at least one latching element (31) adapted to engage a corresponding counter latching element (37) of the plate member (7), the at least one latching element (31) and the corresponding counter latching element, in an engaged state, form a latching (51).

2. Electrical element (1) according to claim 1, wherein the plate insertion section (11) comprises at least one slot (13) for guiding the plate member (7).

3. Electrical element (1) according to claim 2, wherein the at least one slot (13) comprises sectionwise arranged guiding members (53) that are spaced apart from each other along the insertion direction (19).

4. Electrical element (1) according to any one of claims 1 to 3, wherein the plate insertion section (11) comprises a stop (43), limiting the insertion of the plate member (7) along the insertion direction (19), and defining the mounting position (21).

5. Electrical element (1) according to any one of claims 1 to 4, wherein the at least one latching element (31) comprises a spring member (73).

6. Electrical element (1) according to claim 5, wherein the spring member (73) is a bistable spring member (73a).

7. Electrical element (1) according to claim 5 or 6, wherein the spring member (73) is in a latched state (79) if the plate member (7) is in the mounting position (21) and the latching (51) is engaged.

8. Electrical element (1) according to claim 7, wherein in the latched state (79), the spring member (73) is deflected with respect to a rest state (75) of the spring member (73).

9. Electrical element (1) according to any one of claims 1 to 8, wherein the at least one counter latching element (37) comprises a counter latching surface (39), wherein, when the latching (51) is engaged, the at least one latching element (31) of the second housing part (9) presses against the counter latching surface (39), thereby pressing the plate member (7) in the mounting position (21).

10. Electrical element (1) according to claim 9, wherein the counter latching surface (39) comprises a curvature (85) in or opposite to the insertion direction (19).

11. Electrical element (1) according to any one of claims 1 to 10, wherein the at least one latching element (31) is resiliently connected to a body (23) of the second housing member (9) by a push force member (33) adapted to hold the at least one latching element (31) resiliently along the insertion direction (19).

12. Electrical element (1) according to claim 11, wherein the spring member (73) comprises an intermediate state (77) between the rest state (75) and the latched state (79), in which the push force member (33) exerts an intermediate push force onto the plate member (7) in the insertion direction (19).

13. Electrical element (1) according to claim 12, wherein the push force member (33) exerts a permanent push force (95) onto the plate member (7) in the insertion direction (19) in the latched state of the spring member (73), the permanent push force (95) being smaller than the intermediate push force.

14. Electrical element (1) according to any one of claims 11 to 13, wherein the at least one locking element (27) is pressed against the corresponding counter locking element (29) if the at least one latching element (31) is engaged with the corresponding counter latching element (37).

15. Electrical element (1) according to any one of claims 1 to 14, wherein the first housing part (5) comprises two plate insertion sections (11) on opposing sides of the first housing part (5), the plate member (7) being a bent plate member (7) having two ends (65), wherein each of the plate insertion sections (11) is adapted to guide an insertion of one end (65) of the bent plate member (7) into the first housing part (5), and wherein each end (65) of the bent plate member (7) comprises at least one counter latching element (37) adapted to engage a corresponding latching element (31) of the second housing part (9).

16. Electrical element (1) according to claim 14, wherein the second housing part (9) comprises at least two pairs of opposing latching elements (31), at least two latching elements (31) provided on one side of the second housing part (9) being connected to each other by a synchronization member that is adapted to be deflected in a direction perpendicular to the insertion direction (19), thereby moving the at least two latching elements (31) provided on one side of the second housing part (9) from the rest state (75) to the latched state (79).

## Patentansprüche

1. Elektrisches Element (1), aufweisend
- ein erstes Gehäuseteil (5);
- ein Plattenelement (7); und
- ein zweites Gehäuseteil (9),
wobei das erste Gehäuseteil (5) einen Platteneinsetzabschnitt (11) aufweist, wobei der Platteneinsetzabschnitt (11) geeignet ist, einen Einsatz des Plattenelements (7) entlang einer Einsetzrichtung (19) in eine Montageposition (21) des Plattenelements (7) am ersten Gehäuseteil (5) zu führen,
wobei das zweite Gehäuseteil (9) mindestens ein Verriegelungselement (27) aufweist, das mit einem entsprechenden Gegenverriegelungselement (29) des ersten Gehäuseteils (5) eine Verriegelung (49) bildet, und
**dadurch gekennzeichnet, dass** das zweite Gehäuseteil (9) ferner mindestens ein Verriegelungselement (31) umfasst, das geeignet ist, mit einem entsprechenden Gegenverriegelungselement (37) des Plattenelements (7) in Eingriff zu kommen, wobei das mindestens eine Verriegelungselement (31) und das entsprechende Gegenverriegelungselement in einem Eingriffszustand eine Verriegelung (51) bilden.

2. Elektrisches Element (1) nach Anspruch 1, wobei der Platteneinsetzabschnitt (11) mindestens einen Schlitz (13) zur Führung des Plattenelements (7) aufweist.

3. Elektrisches Element (1) nach Anspruch 2, wobei der mindestens eine Schlitz (13) abschnittsweise angeordnete Führungselemente (53) aufweist, die entlang der Einführrichtung (19) voneinander beabstandet sind.

4. Elektrisches Element (1) nach einem der Ansprüche 1 bis 3, wobei der Platteneinsetzabschnitt (11) einen Anschlag (43) aufweist, der den Einsatz des Plattenelements (7) entlang der Einführungsrichtung (19) begrenzt und die Montageposition (21) definiert.

5. Elektrisches Element (1) nach einem der Ansprüche 1 bis 4, wobei das mindestens eine Verriegelungselement (31) ein Federelement (73) umfasst.

6. Elektrisches Element (1) nach Anspruch 5, wobei das Federelement (73) ein bistabiles Federelement (73a) ist.

7. Elektrisches Element (1) nach Anspruch 5 oder 6, wobei sich das Federelement (73) in einem verriegelten Zustand (79) befindet, wenn sich das Plattenelement (7) in der Montageposition (21) befindet und die Verriegelung (51) eingerastet ist.

8. Elektrisches Element (1) nach Anspruch 7, wobei das Federelement (73) in dem verriegelten Zustand (79) gegenüber einem Ruhezustand (75) des Federelements (73) ausgelenkt ist.

9. Elektrisches Element (1) nach einem der Ansprüche 1 bis 8, wobei das mindestens eine Gegenverriegelungselement (37) eine Gegenrastfläche (39) aufweist, wobei bei eingerasteter Verriegelung (51) das mindestens eine Rastelement (31) des zweiten Gehäuseteils (9) gegen die Gegenrastfläche (39) drückt, wodurch das Plattenelement (7) in die Einbaulage (21) gedrückt wird.

10. Elektrisches Element (1) nach Anspruch 9, wobei die Gegenrastfläche (39) eine Krümmung (85) in oder entgegen der Einschubrichtung (19) aufweist.

11. Elektrisches Element (1) nach einem der Ansprüche 1 bis 10, wobei das mindestens eine Verriegelungselement (31) mit einem Körper (23) des zweiten Gehäuseteils (9) durch ein Drucckraftelement (33) elastisch verbunden ist, das geeignet ist, das mindestens eine Verriegelungselement (31) entlang der Einsatzrichtung (19) elastisch zu halten.

12. Elektrisches Element (1) nach Anspruch 11, wobei das Federelement (73) einen Zwischenzustand (77) zwischen dem Ruhezustand (75) und dem verriegelten Zustand (79) aufweist, in dem das Druckkraftelement (33) eine Zwischen-Druckkraft auf das Plattenelement (7) in der Einschubrichtung (19) ausübt.

13. Elektrisches Element (1) nach Anspruch 12, wobei das Druckkraftelement (33) im verrasteten Zustand des Federelements (73) eine permanente Druckkraft (95) auf das Plattenelement (7) in Einsatzrichtung (19) ausübt, wobei die permanente Druckkraft (95) kleiner als die Zwischen-Druckkraft ist.

14. Elektrisches Element (1) nach einem der Ansprüche 11 bis 13, wobei das mindestens eine Verriegelungselement (27) gegen das entsprechende Gegenverriegelungselement (29) gedrückt wird, wenn das mindestens eine Verriegelungselement (31) mit dem entsprechenden Gegenverriegelungselement (37) in Eingriff ist.

15. Elektrisches Element (1) nach einem der Ansprüche 1 bis 14, wobei der erste Gehäuseteil (5) zwei Platteneinsetzabschnitte (11) auf gegenüberliegenden Seiten des ersten Gehäuseteils (5) aufweist, wobei das Plattenelement (7) ein gebogenes Plattenelement (7) mit zwei Enden (65) ist, wobei jeder der Platteneinsetzabschnitte (11) angepasst ist, um einen Einsatz eines Endes (65) des gebogenen Plattenelements (7) in das erste Gehäuseteil (5) zu führen, und wobei jedes Ende (65) des gebogenen Plattenelements (7) mindestens ein Gegenverriegelungselement (37) umfasst, das angepasst ist, um in ein entsprechendes Verriegelungselement (31) des zweiten Gehäuseteils (9) einzugreifen.

16. Elektrisches Element (1) nach Anspruch 14, wobei das zweite Gehäuseteil (9) mindestens zwei Paare von gegenüberliegenden Verriegelungselementen (31) umfasst, wobei mindestens zwei Verriegelungselemente (31), die auf einer Seite des zweiten Gehäuseteils (9) vorgesehen sind, durch ein Synchronisationselement miteinander verbunden sind, das so angepasst ist, dass es in einer Richtung senkrecht zur Einsatzrichtung (19) ausgelenkt wird, wodurch die mindestens zwei Verriegelungselemente (31), die auf einer Seite des zweiten Gehäuseteils (9) vorgesehen sind, aus dem Ruhezustand (75) in den verriegelten Zustand (79) bewegt werden.

## Revendications

1. Élément électrique (1), comprenant
- une première partie de boîtier (5) ;
- un élément de plaque (7) ; et
- une deuxième partie de boîtier (9),
dans lequel la première partie de boîtier (5) comprend une section d'insertion de plaque (11), la section d'insertion de plaque (11) étant adaptée pour guider une insertion de l'élément de plaque (7) selon une direction d'insertion (19) dans une position de montage (21) de l'élément de plaque (7) sur la première partie de boîtier (5),
dans lequel la deuxième partie de boîtier (9) comprend au moins un élément de verrouillage (27) qui forme un verrouillage (49) avec un élément de contre-verrouillage (29) correspondant de la première partie de boîtier (5), et
**caractérisé en ce que**
la deuxième partie de boîtier (9) comprend en outre au moins un élément **d'enclenchement** (31) adapté pour s'engager dans un élément de contre-enclenchement (37) correspondant de l'élément de plaque (7),
ledit au moins un élément **d'enclenchement** (31) et ledit élément de contre-enclenchement correspondant, dans un état engagé, forment un enclenchement (51).

2. Élément électrique (1) selon la revendication 1, dans lequel la section d'insertion de plaque (11) comprend au moins une fente (13) pour guider **l'élément** de plaque (7).

3. Élément électrique (1) selon la revendication 2, dans lequel ladite au moins une fente (13) comprend des éléments de guidage (53) agencés en sections, qui sont espacés les uns des autres selon la direction d'insertion (19).

4. Élément électrique (1) selon l'une quelconque des revendications 1 à **3,** dans lequel la section d'insertion de plaque (11) comprend une butée (43) qui limite l'insertion de l'élément de plaque (7) selon la direction d'insertion (19) et définit la position de montage (21).

5. Élément électrique (1) selon l'une quelconque des revendications 1 à 4, dans lequel ledit au moins un élément d'enclenchement (31) comprend un élément à ressort (73).

6. Élément électrique (1) selon la revendication **5,** dans lequel l'élément à ressort (73) est un élément à ressort bistable (73a).

7. Élément électrique (1) selon la revendication 5 ou **6,** dans lequel l'élément à ressort (73) est dans un état enclenché (79) si l'élément de plaque (7) est dans la position de montage (21) et l'enclenchement (51) est engagé.

8. Élément électrique (1) selon la revendication 7, dans lequel, dans l'état enclenché (79), l'élément à ressort (73) est défléchi par rapport à un état de repos (75) de l'élément à ressort (73).

9. Élément électrique (1) selon l'une quelconque des revendications 1 à 8, dans lequel ledit au moins un élément de contre-enclenchement (37) comprend une surface de contre-enclenchement (39), dans lequel, quand l'enclenchement (51) est engagé, ledit au moins un élément d'enclenchement (31) de la deuxième partie de boîtier (9) pousse contre la surface de contre-enclenchement (39), poussant ainsi l'élément de plaque (7) dans la position de montage (21).

10. Élément électrique (1) selon la revendication 9, dans lequel la surface de contre-enclenchement (39) comprend une courbure (85) dans la direction d'insertion (19) ou à l'opposé de celle-ci.

11. Élément électrique (1) selon l'une quelconque des revendications 1 à 10, dans lequel ledit au moins un élément d'enclenchement (31) est connecté de manière élastique à un corps (23) du deuxième élément de boîtier (9) par un élément de force de poussée (33) adapté pour maintenir ledit au moins un élément d'enclenchement (31) de manière élastique selon la direction d'insertion (19).

12. Élément électrique (1) selon la revendication 11, dans lequel l'élément à ressort (73) comprend un état intermédiaire (77) entre l'état de repos (75) et l'état enclenché (79), où l'élément de force de poussée (33) exerce une force de poussée intermédiaire sur l'élément de plaque (7) dans la direction d'insertion (19).

13. Élément électrique (1) selon la revendication 12, dans lequel l'élément de force de poussée (33) exerce une force de poussée permanente (95) sur l'élément de plaque (7) dans la direction d'insertion (19) dans l'état enclenché de l'élément à ressort (73), la force de poussée permanente (95) étant inférieure à la force de poussée intermédiaire.

14. Élément électrique (1) selon l'une quelconque des revendications 11 à 13, dans lequel ledit au moins un élément de verrouillage (27) est poussé contre l'élément de contre-verrouillage (29) correspondant si ledit au moins un élément d'enclenchement (31) est engagé avec l'élément de contre-enclenchement (37) correspondant.

15. Élément électrique (1) selon l'une quelconque des revendications 1 à 14, dans lequel la première partie de boîtier (5) comprend deux sections d'insertion de plaque (11) sur des côtés opposés de la première partie de boîtier (5), l'élément de plaque (7) étant un élément de plaque courbé (7) comportant deux extrémités (65), dans lequel chacune des sections d'insertion de plaque (11) est adaptée pour guider l'insertion d'une extrémité (65) de l'élément de plaque courbé (7) dans la première partie de boîtier (5), et dans lequel chaque extrémité (65) de l'élément de plaque courbé (7) comprend au moins un élément de contre-enclenchement (37) adapté pour s'engager dans un élément d'enclenchement (31) correspondant de la deuxième partie de boîtier (9).

16. Élément électrique (1) selon la revendication 14, dans lequel la deuxième partie de boîtier (9) comprend au moins deux paires d'éléments d'enclenchement opposés (31), au moins deux éléments d'enclenchement (31) pourvus sur un côté de la deuxième partie de boîtier (9) étant connectés l'un à l'autre par un élément de synchronisation qui est adapté pour être défléchi dans une direction perpendiculaire à la direction d'insertion (19), déplaçant ainsi lesdits au moins deux éléments d'enclenchement (31) pourvus sur un côté de la deuxième partie de boîtier (9) de l'état de repos (75) à l'état enclenché (79).
